# EUROPEAN PATENT SPECIFICATION

(11) **EP 2 705 606 B1**
(45) Date of publication and mention of the grant of the patent: **08.07.2015**
(21) Application number: 12726197.2
(22) Date of filing: 03.05.2012
(51) Int. Cl.: H03G 3/30, H04B 1/16

(54) **RECEIVER OF RADIO FREQUENCY SIGNALS**
EMPFÄNGER VON RADIOFREQUENZSIGNALEN
RÉCEPTEUR DE SIGNAUX RADIOFRÉQUENCE

(30) Priority: 05.05.2011 IT MI20110756
(43) Date of publication of application: 12.03.2014
(73) Proprietor: STE s.r.l., 20134 Milano (IT)
(72) Inventor: MOIRAGHI, Guido, I-20133 Milano (IT); MOIRAGHI, Luca, I-20133 Milano (IT); MOIRAGHI, Paolo, I-27020 Marcignago (PV) (IT)
(74) Representative: Mittler, Enrico
(86) International application number: PCT/IB2012/052212
(87) International publication number: WO 2012/150565

(56) References cited:
- US-A- 5 175 883
- US-A1- 2007 207 760
- US-B1- 7 151 759

## Description

The present invention relates to a receiver of radiofrequency signals.

Most of the current receivers of radiofrequency signals use a complex circuit structure, typically of the superheterodyne type. Said receivers comprise a mixer, an oscillator for generating the heterodyne signal and a PLL circuit adapted to stabilize the receiver frequency.

In particular, in the case of devices for transmitting and receiving information related to some parts of the vehicle, such as for example the correct level of liquid in a tank, temperature and pressure in a tire, the battery status and so on, receivers are often integrated in the onboard computer or located in a more suitable position for receiving signals inside the vehicle and communicating with the onboard computer. The data received by the receiver are transmitted to the computer inside the motor vehicle for displaying simple information messages or alert conditions on a dedicated display.

However, current receivers are complex especially due to the presence of a phase detector adapted to compare two signals at different frequencies and to emit a signal with a phase proportional to the phase difference of the two signals at different frequencies.

In addition, said receivers absorb significant levels of current and actuate a consequent energy dissipation.

US 7151759 discloses a digital AGC system for burst operation, particularly suited for receiving packets in a wireless local area network. One embodiment includes a log detector that provides a signal strength measure, called the received signal strength indication (RSSI) over a wide dynamic range. The AGC system includes estimating the power in a received signal by averaging the log of the signal power. The Start of Packet detection avoids using the radio receiver's main analog to digital converters to preserve power.

US 2007/207760 discloses a system for filter calibration using fractional-N frequency synthesized signals. Aspects of the system may include a single-chip multi-band RF receiver that enables generation of a LO signal by a PLL circuit within the single-chip, and enables calibration of a frequency response for a filter circuit integrated within the chip. A reference signal may be generated based on the generated LO signal and a synthesizer control signal. The frequency response may be calibrated by adjusting the filter based on the generated reference signal.

US 5175883 discloses a receiving apparatus comprising a high frequency amplifying circuit for amplifying a signal received from an antenna by a gain in accordance with a control signal, a frequency conversion circuit for converting the output frequency of the high frequency amplifying circuit, a narrow band filter for selectively passing therethrough the intermediate frequency signal components of the output of the frequency conversion circuit, and control signal generating circuit for generating a control signal in accordance with the output level of the frequency conversion circuit. The control signal generating circuit is so constructed that the control signal generating circuit outputs the control signal only when the output signal level of the frequency conversion circuit is higher than a level in accordance with the level of the narrow band filter.

In view of the prior art, the object of the present invention is to provide a receiver of radiofrequency signals which is circuit-wise simpler than known ones and has a lower current absorption than known ones.

According to the present invention, said object is achieved by a receiver of at least one radiofrequency modulated signal deriving from an antenna external to the receiver, said receiver comprising a first stage for the low noise amplification of the radiofrequency modulated signal and a demodulation stage of the radiofrequency modulated signal, characterized by comprising a SAW filter adapted to act as a pass band filter about a predetermined frequency for the signal deriving from the first stage, a logarithmic amplifier adapted to amplify the signal deriving from the SAW filter, a peak detector of the output signal of the logarithmic amplifier, means adapted to control the gain of the first stage for the amplification of the radiofrequency signal as a function of the output signal of the peak detector, said output signal of the logarithmic amplifier and said output signal of the peak detector being in input to the demodulation stage.

Due to the present invention it is possible to provide a receiver of radiofrequency signals particularly suitable to be used in short-range data transmission and reception systems such as car door opening systems or tire pressure monitoring systems.

The receiver is particularly suitable for receiving signals with pulse position modulation (PPM) or with pulse width modulation (PWM).

The features and the advantages of the present invention will appear more clearly from the following detailed description of a practical embodiment thereof, made by way of a non-limiting example with reference to the annexed drawings, wherein:
figure 1 shows a block diagram of the receiver of radiofrequency signals according to the present invention;
figure 2 shows a circuit scheme of the low noise preamplifier stage of the receiver of figure 1;
figure 3 shows a circuit scheme of the filtering stage of the receiver of figure 1;
figure 4 shows a diagram of the frequency response of the filtering stage of figure 3;
figure 5 shows a circuit scheme of the logarithmic amplifier of the receiver of figure 1;
Figure 6 shows a diagram of the output voltage as a function of the input signal level of the stage in figure 5;
figure 7 shows a circuit scheme of the "ASK" and "PURSE" comparators used in the receiver of figure 1;
figure 8 schematically shows a package with the receiver of figure 1 made in a substrate of ceramic material according to an embodiment of the present invention;
figure 9 schematically shows a package with the receiver of figure 1 and a microcontroller made in a substrate of ceramic material according to a variant of the embodiment of the invention.

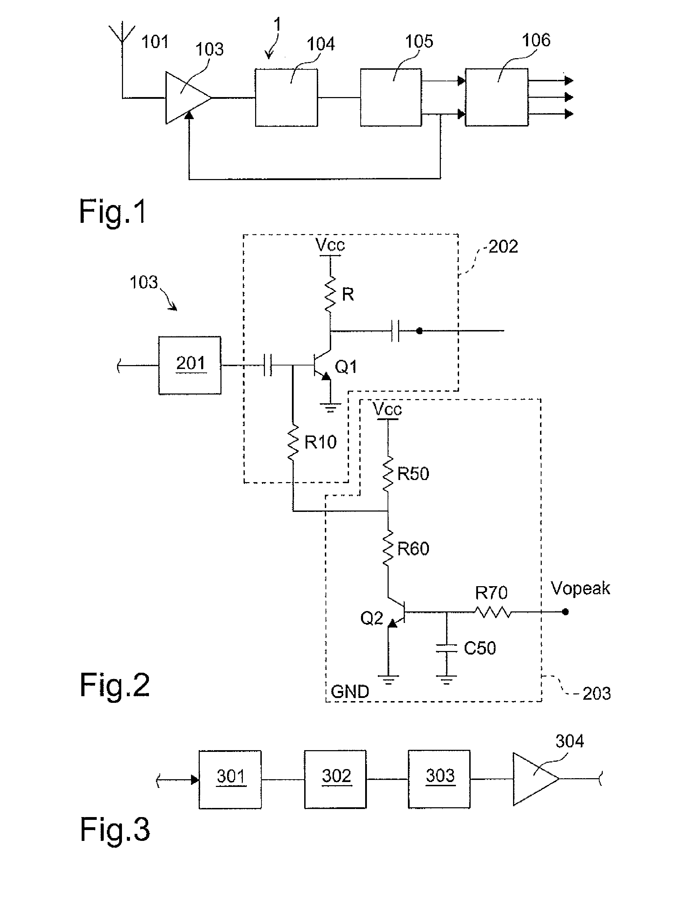

With reference to figure 1, there is shown a receiver 1 of radiofrequency signals according to the present invention. The receiver comprises a preamplifier stage 103 of a radiofrequency signal received by an antenna 101, a filtering stage 104, an amplification stage 105 and a signal demodulation stage 106.

The signal deriving from antenna 101 is at the input to the low noise preamplifier stage 103 comprising, as better seen in figure 2, a pass band filter 201 tuned to the reception frequency; the filter 201 also has the function of impedance adapter.

The output signal of filter 201 is transmitted to a circuit block 202 comprising a radiofrequency transistor Q1 controlled by the output signal to a circuit 203; the output signal from transistor Q1 flows through a low value resistance R, preferably about 100 Ohm, such as to have a constant impedance at the input of the next stage. The transistor Q1 is preferably a common emitter bipolar transistor. The circuit block 202 represents a low noise amplifier stage the gain G of which is controlled by the circuit 203.

The circuit 203 is controlled by signal Vopeak deriving from a peak detector 402 belonging to receiver 1. Circuit 203 comprises a transistor Q2, preferably a common emitter bipolar transistor with the emitter terminal connected to ground GND. The base terminal of transistor Q2 is driven by signal Vopeak filtered by the low pass filter R70*C50. The signal on the collector terminal of transistor Q2 drives the base terminal of transistor Q1 and varies the base bias current of the transistor Q1 for varying, in particular for decreasing, the gain G of transistor Q1 proportionally to the signal intensity on the antenna; therefore, circuit 203 forms an automatic gain control block. When the signal Vopeak increases, the transistor Q2 acts so as to reduce the gain G of the transistor Q1; the gain G of the bipolar transistor Q1 is inversely proportional to the amplitude of signal Vopeak.

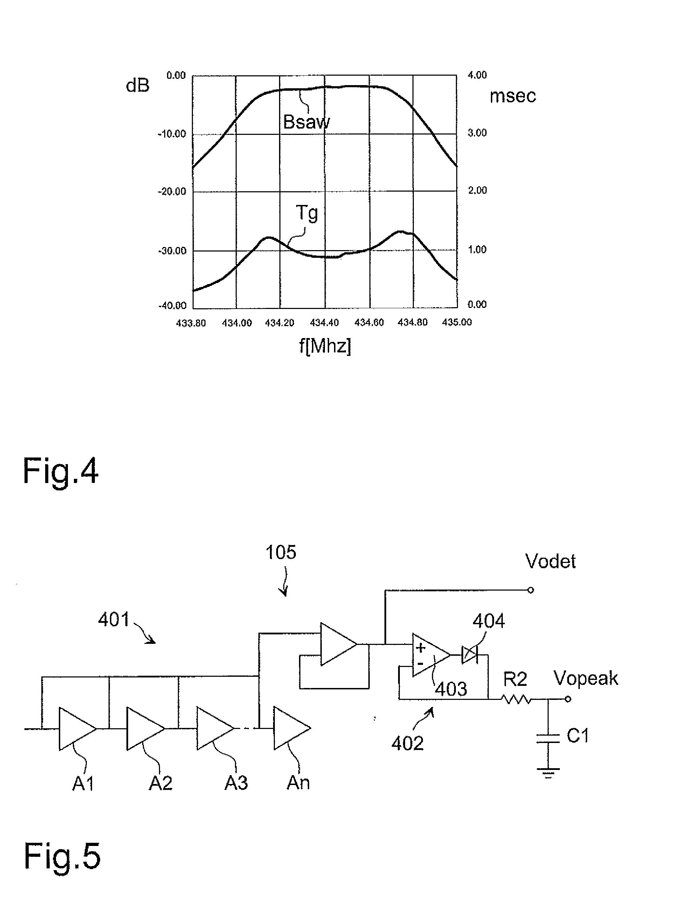

The output signal of the stage 103 is at the input of a SAW filter 302 of the stage 104, better shown in figure 3, which must select the signals in a channel between 300 and 600 kHz, i.e. it must filter the signals in a pass band from 300 to 600 kHz and must ensure a constant group delay time Tg, where the group delay time indicates the variation of the passage time of a signal through the pass band Bsaw of the SAW filter. The impedance adapter circuits 301 and 303, arranged at the input and at the output of the SAW filter 302, are configured for obtaining a constant group delay time Tg on the whole pass band Bsaw of the SAW filter 302. Figure 4 shows the variation of the band and of the group delay time Tg as a function of the frequency for filter SAW of figure 3. The output signal of filter SAW 302 is amplified by a fixed gain amplifier 304.

The constancy of the group delay time Tg allows a correct amplification of the rising and falling edges of the radiofrequency modulated signal, such as for example when the modulated signal is a signal with pulse width modulation (PWM) or with pulse position modulation (PPM) where for example the radiofrequency pulses have rising and falling edges in the order of 100 nanoseconds.

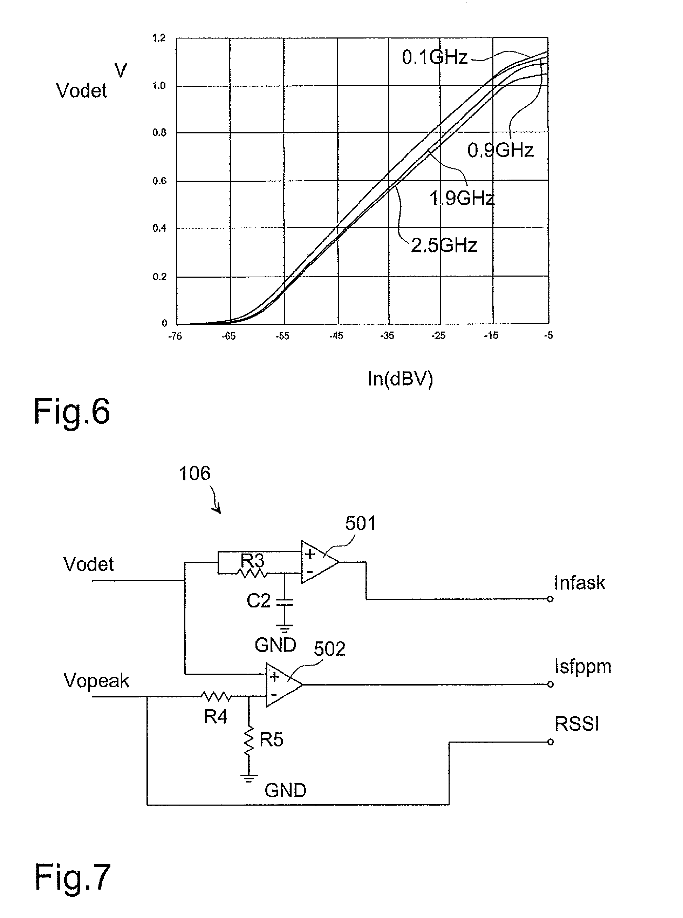

The output signal of amplifier 304 is at the input of a logarithmic amplifier 401, shown in figure 5, belonging to stage 105 and adapted to amplify the input signal. The logarithmic amplifier 401 is a temperature-compensated amplifier and performs a high gain by the series of multiple amplification stages Ai...An. Figure 6 shows a diagram of the waveform of the output voltage Vodet as a function of the input signal level In of the logarithmic amplifier 401 at different frequencies.

The output signal Vodet of the logarithmic amplifier is transmitted to a demodulation stage for demodulating the information. The same output signal Vodet of the logarithmic amplifier 401 is transmitted to a peak detector 402 adapted to detect the peaks of the output signals of the logarithmic amplifier 401. Preferably, the peak detector 402 comprises an operational amplifier 403 having the output signal of the logarithmic amplifier 401 at the non-inverting input terminal, having the output connected with the anode of a diode 404 having the cathode connected with the inverting input terminal and with the terminal of a resistance R2 having the other terminal connected with the terminal of a capacitor C1 in turn connected to ground GND; the time constant related to capacitor C1 has a small value, about one microsecond. The voltage Vopeak at the terminals of capacitor C1 is the output of the peak detector. The output signal Vopeak is transmitted to a comparator adapted to carry out the signal demodulation and is used by the circuit 203 for controlling the radiofrequency transistor 202. The resistance R2 has a low value, preferably 22 Ohm, and serves for stabilizing the circuit operation compensating the signal propagation delays by means of the operational amplifier.

Finally, signals Vodet and Vopeak are transmitted to the demodulation stage 106 for digitally reconstructing the information contained in the received modulated signal, as better shown in figure 7. The comparator 501 carries out a demodulation in case of signal modulated with amplitude modulation ASK (Amplitude shift Keying) or also an OOK (On-Off Keying) modulation; the comparator 501 receives the signal Vodet at the non-inverting input thereof, while at the inverting input thereof there is the average value of signal Vodet mediated by a circuit comprising a resistance R3 connected with a capacitor C2 in turn connected to ground GND and with the inverting input. The output signal of comparator 501 is the signal Infask. The output signal Vopeak is transmitted as the signal RSSI.

The comparator 502 carries out a demodulation in the case of signal modulated with pulse position modulation PPM or with pulse with modulation PWM; the comparator 504 receives the signal Vodet at the non-inverting input thereof, while at the inverting input thereof there is a reference signal derived by the resistive divider consisting of resistances R4 and R5 and the signal Vopeak is present across the series of the resistances R4 and R5. The values of resistances R4 and R5 and of capacitor C1 determine the decay time constant of the output voltage Vopeak; said time constant, generally of the order of few milliseconds, takes on a major importance if the signals received are affected by sudden amplitude variations, as in the signals used for transmitting the tire pressure. The output signal of comparator 502 is the signal Infppm. The signals Infask, Infppm and RSSI are the output signals of the demodulation stage 106 and of the receiver 1.

In particular, the receiver according to the present invention is more suitable in data transmission reception systems arranged in vehicles, preferably motor vehicles. The transmitters may be located in various parts of the motor vehicle, for example next to the battery or in the tires for transmitting data on the tire temperature or the tire pressure.

The receiver is adapted to receive said data and transfer them to a central computer for displaying alarms or messages on a display.

Preferably, in the case of transmission of tire pressure data with pulse position modulation, the signal transmitted starts after a given period of time by the triggering of the oscillations with the generation of a first pulse that represents the beginning of the message and has a width W typically of 3 microseconds. Other subsequent pulses are then generated, the temporal positions thereof, i.e. the periods of time between one pulse and the next one, represent the content of the information to be transmitted.

The receiver according to the invention is particularly suitable for receiving data modulated according to a pulse position modulation.

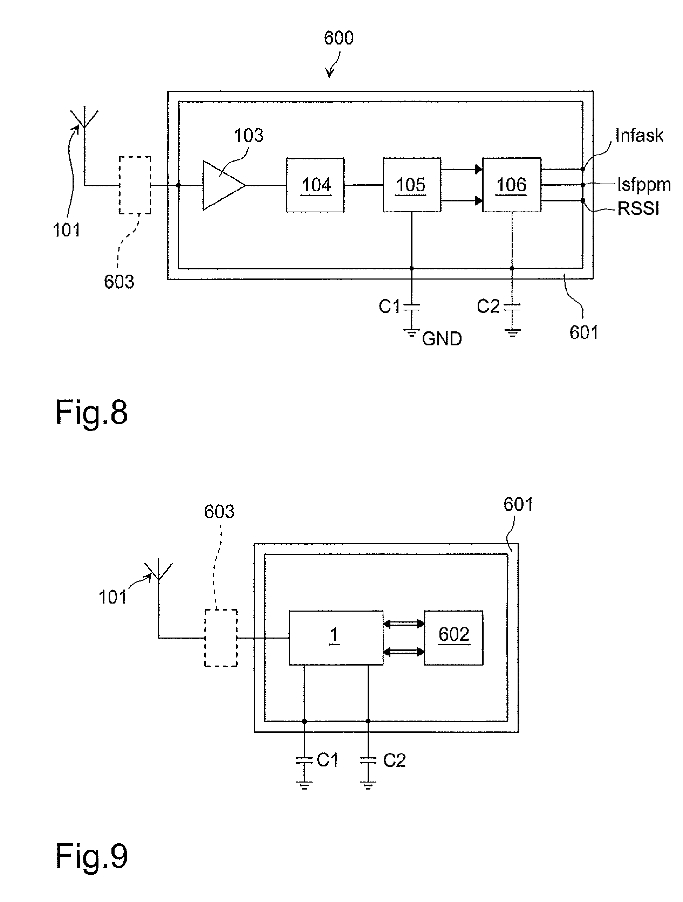

According to the invention it is possible to make a package 600, also called package LTCC, wherein receiver 1 shown in figures 1-6 is made in a substrate of ceramic material 601 using the LTCC (Low Temperature Cofired Ceramic) technology, as shown in figure 8. The receiver is integrally manufactured in the ceramic substrate except for capacitors C1 of the peak detector 402 and C2 of demodulator 106; said capacitors are accessible from the outside for adapting the time constants of the peak detector and of the demodulator to the different requirements of the receiver.

Figure 9 shows a package according to a variant of the embodiment of the present invention; the package comprises a microcontroller 602 coupled to the receiver 1 wherein the microcontroller 602 is adapted to manage the PPM modulated signals received.

## Claims

1. A receiver (1) of at least one radiofrequency modulated signal deriving from an antenna (101) external to the receiver, said receiver comprising a first stage (103) for the low noise amplification of the radiofrequency modulated signal and a demodulation stage (106) of the radiofrequency modulated signal, **characterized by** comprising a SAW filter (104) adapted to act as a pass band filter about a predetermined frequency for the signal deriving from the first stage, a logarithmic amplifier (401) adapted to amplify the signal deriving from the SAW filter, a peak detector (402) of the output signal of the logarithmic amplifier, means (203) adapted to control the gain (G) of the first stage (103) for the amplification of the radiofrequency modulated signal as a function of the output signal (Vopeak) of the peak detector, said output signal (Vodet) of the logarithmic amplifier and said output signal (Vopeak) of the peak detector being in input to the demodulation stage (106).

2. A receiver according to claim 1, **characterized in that** said means (203) are adapted to reduce the gain (G) of the first stage (103) of the amplification of the radiofrequency modulated signal in correspondence of a value increase of the output signal of the peak detector, said means being adapted to increase the gain (G) of the first stage of amplification of the radiofrequency modulated signal in correspondence of a value reduction of the output signal of the peak detector.

3. A receiver according to claim 1, **characterized in that** said means (203) comprise a first common emitter bipolar transistor (Q2) the base terminal of which is controlled by the output signal (Vopeak) of the peak detector, said first amplification stage (103) comprising a second common emitter bipolar transistor (Q1), the current flowing through the base terminal of said second bipolar transistor (Q1) depending on the current flowing through the collector terminal of the first bipolar transistor.

4. A receiver according to claim 1, **characterized in that** said peak detector (402) comprises at least one capacitor (C1) the value of which determines the decay constant of the output signal of the peak detector.

5. A receiver according to claim 4, **characterized in that** said peak detector (402) comprises a operational amplifier (403) having the output signal of the logarithmic amplifier (401) at the non-inverting input terminal, the output terminal connected with the anode of a diode having the cathode connected with the inverting input terminal of the operational amplifier and with one terminal of a resistance (R2) having the other terminal connected with one terminal of said capacitor (C1) having the other terminal connected to a reference voltage (GND).

6. A receiver according to any one of the claims from 1 to 3, **characterized in that** said demodulator (106) comprises means (R3, C2) adapted to average the output signal of the logarithmic amplifier, said means comprising at least a further capacitor (C2).

7. An LTCC package (600) comprising a receiver (1) as defined in any one of the preceding claims which is manufactured in a ceramic material substrate (601) and wherein the at least one capacitor (C1) and at least a further capacitor (C2) are external to the package.

8. An LTCC package according to claim 7, **characterized by** comprising a microcontroller (602) manufactured in said ceramic material substrate (601), said receiver being adapted to interact with said microcontroller.

## Patentansprüche

1. Empfänger (1) von mindestens einem radiofrequenz-modulierten Signal, welches von einer Antenne (101), die außerhalb des Empfängers angeordnet ist, empfangen wird, wobei der Empfänger eine erste Stufe (103) für die rauscharme Verstärkung des radiofrequenz-modulierten Signals und eine Demodulationsstufe (106) für das radiofrequenz-modulierte Signal umfasst,
**gekennzeichnet durch** einen SAW-Filter (104), der so ausgestaltet ist, um als ein Filter mit einem Durchlassbereich um eine vorbestimmte Frequenz für das Signal, welches von der erste Stufe erlangt wird, zu agieren,
einen logarithmischen Verstärker (401), der so ausgestaltet ist, das Signal, welches vom SAW-Filter erlangt worden ist, zu verstärken,
einen Peak-Detektor (402) des Ausgangssignals des logarithmischen Verstärkers, Mittel (203), die so ausgestaltet sind, die Verstärkung (G) der ersten Stufe (103) für die Verstärkung des radiofrequenz-modulierten Signals als eine Funktion des Ausgangssignals (Vopeak) des Peak-Detektors (Vodet) zu regeln, wobei das Ausgangssignal des logarithmischen Verstärkers und das Ausgangssignals (Vopeak) des Peak-Detektors der Eingang in die Demodulationsstufe (106) sind.

2. Empfänger nach Anspruch 1, **dadurch gekennzeichnet, dass** die Mittel (203) so ausgestaltet sind, die Verstärkung (G) der ersten Stufe (103) der Verstärkung des radiofrequenz-modulierten Signals in Verbindung mit einem Wertzuwachs des Ausgangssignals des Peak-Detektors zu reduzieren, wobei die Mittel so ausgestaltet sind, die Verstärkung (G) der ersten Stufe der Verstärkung des radiofrequenz-modulierten Signals in Verbindung mit einer Wertverminderung des Ausgangssignals des Peak-Detektors zu erhöhen.

3. Empfänger nach Anspruch 1, **dadurch gekennzeichnet, dass** die Mittel (203) einen ersten gemeinsamen Emitter-Bipolartransistor (Q2) umfassen, dessen Basisanschluss vom Ausgangssignal (Vopeak) des Peak-Detektors geregelt wird, wobei die erste Verstärkungsstufe (103) einen zweiten gemeinsamen Emitter-Bipolartransistor (Q1) umfasst und der Strom in Abhängigkeit von dem Strom durch den Basisanschluss des zweiten Emitter-Bipolartransistor (Q1) fließt, der durch den Kollektoranschluss des ersten Bipolartransistors fließt.

4. Empfänger nach Anspruch 1, **dadurch gekennzeichnet, dass** der Peak-Detektor (402) mindestens einen Kondensator (C1) umfasst, dessen Wert die Zerfallskonstante des Ausgangssignals des Peak-Detektors bestimmt.

5. Empfänger nach Anspruch 4, **dadurch gekennzeichnet, dass** der Peak-Detektor (402) einen betriebsbereiten Verstärker (403) umfasst, an dem das Ausgangssignal des logarithmischen Verstärkers (401) am nichtinvertierenden Eingangsanschluss anliegt, wobei das Ausgangssignal mit der Anode einer Diode verbunden ist, bei welcher die Kathode mit dem invertierenden Eingangsanschluss des betriebsbereiten Verstärkers und mit einem Widerstandsanschluss (R2) verbunden ist, bei dem der andere Anschluss mit einem Anschluss des Kondensators (C1) verbunden ist, bei dem der andere Anschluss mit einer Referenzspannung (GND) verbunden ist.

6. Empfänger nach einem der Ansprüche 1 bis 3, **dadurch gekennzeichnet, dass** der Demodulator (106) Mittel (R3, C2) umfasst, die so ausgebildet sind, das Ausgangssignal des logarithmischen Verstärkers zu mitteln, wobei die Mittel mindestens einen weiteren Kondensator (C2) aufweisen.

7. LTCC-Gehäuse (600) umfassend einen Empfänger (1) nach einem der vorherigen Ansprüche, der in einem Substrat aus keramischem Material (601) hergestellt ist und wobei der mindestens eine Kondensator (C1) und mindestens ein weiterer Kondensator (C2) außerhalb des Gehäuses angeordnet sind.

8. LTCC-Gehäuse nach Anspruch 7, **gekennzeichnet durch** einen Mikrokontroller (602), der im Substrat aus keramischem Material (601) hergestellt ist, wobei der Empfänger so ausgebildet ist, um mit dem Mikrokontroller zusammenzuwirken.

## Revendications

1. Récepteur (1) d'au moins un signal modulé à fréquence radio dérivé d'une antenne (101) extérieure au récepteur, ledit récepteur comprenant un premier étage (103) pour l'amplification à bas bruit du signal modulé à fréquence radio et un étage de démodulation (106) du signal modulé à fréquence radio, **caractérisé en ce qu'**il comprend un filtre à ondes de surface (104) adapté de façon à jouer le rôle de filtre passe-bande autour d'une fréquence prédéterminée pour le signal dérivé du premier étage, un amplificateur logarithmique (401) adapté de façon à amplifier le signal dérivé du filtre à ondes de surface, un détecteur de pic (402) du signal de sortie de l'amplificateur logarithmique, des moyens (203) adaptés de façon à commander le gain (G) du premier étage (103) pour l'amplification du signal modulé à fréquence radio en fonction du signal de sortie (Vopeak) du détecteur de pic, ledit signal de sortie (Vodet) de l'amplificateur logarithmique et ledit signal de sortie (Vopeak) du détecteur de pic étant en entrée sur l'étage de démodulation (106).

2. Récepteur selon la revendication 1, **caractérisé en ce que** lesdits moyens (203) sont adaptés de façon à réduire le gain (G) du premier étage (103) de l'amplification du signal modulé à fréquence radio en correspondance avec une augmentation de valeur du signal de sortie du détecteur de pic, lesdits moyens étant adaptés de façon à augmenter le gain (G) du premier étage d'amplification du signal modulé à fréquence radio en correspondance avec une réduction de valeur du signal de sortie du détecteur de pic.

3. Récepteur selon la revendication 1, **caractérisé en ce que** lesdits moyens (203) comprennent un premier transistor bipolaire à émetteur commun (Q2) dont la borne de base est commandée par le signal de sortie (Vopeak) du détecteur de pic, ledit premier étage d'amplification (103) comprenant un deuxième transistor bipolaire à émetteur commun (Q1), le courant circulant à travers la borne de base dudit deuxième transistor bipolaire (Q1) dépendant du courant circulant à travers la borne de collecteur du premier transistor bipolaire.

4. Récepteur selon la revendication 1, **caractérisé en ce que** ledit détecteur de pic (402) comprend au moins un condensateur (C1) dont la valeur détermine la constante de décroissance du signal de sortie du détecteur de pic.

5. Récepteur selon la revendication 4, **caractérisé en ce que** ledit détecteur de pic (402) comprend un amplificateur opérationnel (403) ayant le signal de sortie de l'amplificateur logarithmique (401) sur la borne d'entrée non inverseuse, la borne de sortie étant connectée à l'anode d'une diode ayant la cathode connectée à la borne d'entrée inverseuse de l'amplificateur opérationnel et à une borne d'une résistance (R2) ayant l'autre borne connectée à une borne dudit condensateur (C1) ayant l'autre borne connectée à une tension de référence (GND (MASSE)).

6. Récepteur selon l'une quelconque des revendications 1 à 3, **caractérisé en ce que** ledit démodulateur (106) comprend des moyens (R3, C2) adaptés de façon à réaliser une moyenne du signal de sortie de l'amplificateur logarithmique, lesdits moyens comprenant au moins un autre condensateur (C2).

7. Ensemble en céramique cocalcinée à basse température (600), comprenant un récepteur (1) selon l'une quelconque des revendications précédentes, qui est fabriqué dans un substrat en matériau céramique (601), et dans lequel le condensateur au nombre d'au moins un (C1) et au moins un autre condensateur (C2) sont extérieurs à l'ensemble.

8. Ensemble en céramique cocalcinée à basse température selon la revendication 7, **caractérisé en ce qu'**il comprend un micro-dispositif de commande (602) fabriqué dans ledit substrat en matériau céramique (601), ledit récepteur étant adapté de façon à interagir avec ledit micro-dispositif de commande.
